# EUROPEAN PATENT SPECIFICATION

(11) **EP 2 672 512 B1**
(45) Date of publication and mention of the grant of the patent: **22.05.2019**
(21) Application number: 13169616.3
(22) Date of filing: 29.05.2013
(51) Int. Cl.: H01L 23/473, H01L 23/373

(54) **Cold plate assembly incorporating thermal heat spreader**
Kühlplattenanordnung mit einem Wärmeverteiler
Ensemble de plaque froide incorporant un dissipateur de chaleur thermique

(30) Priority: 07.06.2012 US 201213490538
(43) Date of publication of application: 11.12.2013
(73) Proprietor: Hamilton Sundstrand Space Systems International, Inc., Windsor Locks, CT 06096 (US)
(72) Inventor: Zaffetti, Mark A., Suffield, CT Connecticut 06078 (US); Strange, Jeremy M., Windsor, CT Connecticut 06095 (US)
(74) Representative: Dehns

(56) References cited:
- EP-A2- 2 372 759
- US-A1- 2006 063 018
- US-A1- 2009 034 204

## Description

### BACKGROUND

This disclosure generally relates to a cooling structure for cooling electronic components. More particularly, this disclosure relates to a cooling structure including a cold plate support assembly.

Electronic components onboard aircraft or other vehicles that operate in extreme temperatures are typically protected from overheating by a cooling device. In some environments, air flow is either not available or insufficient to handle the thermal loads generated by the electronic components. In such applications, a cold plate is utilized through which a cooling fluid flows to remove heat from the electronic component. The cold plate is mounted adjacent the electronic component and supplied with fluid flow through appropriate conduits that lead to a fluid delivery system. EP 2372759 A2 describes a cold plate assembly with an integral cold plate and structural member. US 2006/063018 A1 describes a finstock material for heat dissipation. US 2009/034204 A1 describes an apparatus for transferring heat from a heat spreader.

### SUMMARY

A cold plate assembly is described according to claim 1.

Although the different examples have the specific components shown in the illustrations, embodiments of this invention are not limited to those particular combinations. It is possible to use some of the components or features from one of the examples in combination with features or components from another one of the examples.

These and other features disclosed herein can be best understood from the following specification and drawings, the following of which is a brief description.

### BRIEF DESCRIPTION OF THE DRAWINGS

Figure 1 is a perspective view of an example cold plate assembly.
Figure 2 is a cross section of the example cold plate assembly.
Figure 3 is an exploded view of the example cold plate assembly.
Figure 4 is a perspective view of an example ruffled fin assembly.
Figure 5 is a perspective view of an example heat spreader assembly.

### DETAILED DESCRIPTION

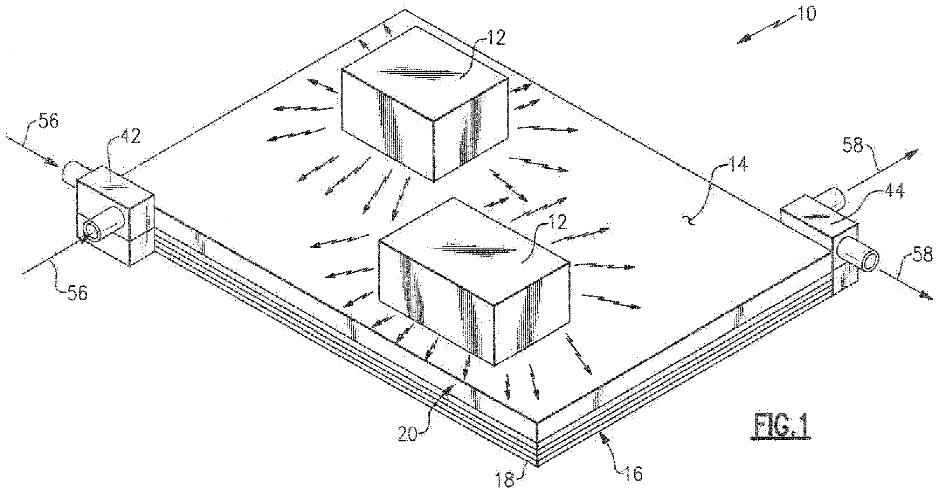

Referring to Figure 1, an example cold plate assembly 10 includes an upper mounting surface 14 and a bottom surface 16. The upper mounting surface 14 defines an area for mounting heat generating devices 12. The example heat generating devices 12 are electronic components that generate heat dissipated through the cold plate assembly 10. The example cold plate assembly 10 includes fluid inlet fitting 42 that receive a cooling medium input indicated at 56 that removes heat from the cold plate assembly 10 generated by the heat generating device 12 and carries the heated cooling medium away through outlet fitting 44 as indicated at 58. Further, although the example structural cooling plate assembly 10 includes two separate cooling circuits any number of cooling circuits are also within the contemplation of this disclosure.

As appreciated, the heat generating devices 12 are mounted to a specific location on the mounting surface 14. Accordingly, generated heat is not evenly produced across the mounting surface 14.

The example mounting surface 14 is part of an upper skin 22 of a heat spreading assembly 20. A heat spreading assembly 20 provides for not only the dissipation of heat within a localized area but a spreading of the heat across a much wider area or surface to evenly distribute thermal energy produced by locally mounted heat generating devices 12. The example heat spreader assembly 20 is an integral part of the cold plate assembly 10 and defines the mounting surface 14 on which the various heat generating devices 12 are mounted.

As appreciated, the example mounting surface 14 is indicated as a planar surface for mounting of the various heat generating devices 12. However, the mounting surface 14 could be of any shape desired to accommodate application specific mounting requirements for the various heat generating devices. Moreover, although the example heat generating devices 12 are described as electronic components they may also comprise any other devices that generate heat that are desired to be cooled through a passive means as is provided by the example cold plate assembly 10.

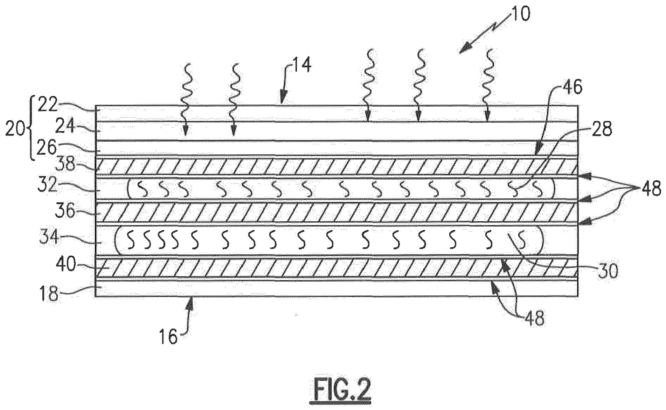

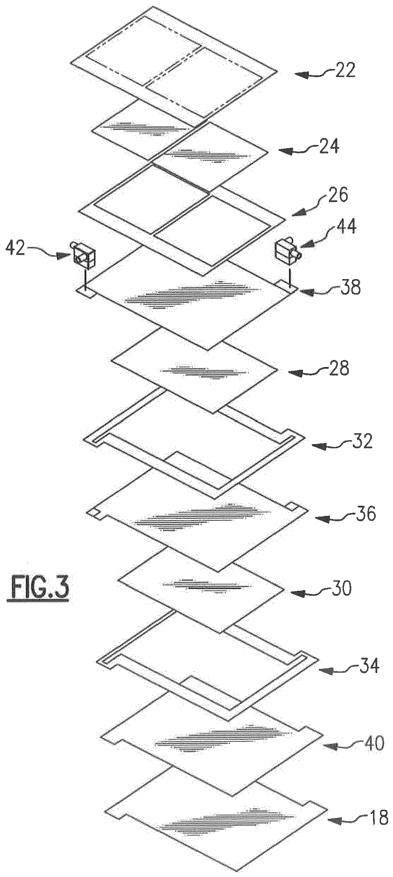

Referring to Figures 2 and 3 with continued reference to Figure 1, the example cold plate assembly 10 is made up of a plurality of layers. Heat generated by the heat generating devices 12 is initially absorbed through the mounting surface 14 into the cold plate assembly 10. Heat produced by the heat producing devices 12 is spread out across the area defined by the heat spreader assembly 20 comprising the mounting surface 14. The heat is then absorbed within the cold plate assembly 10 through the various layers illustrated in Figure 2.

The example cold plate assembly 10 includes the heat spreader 20 that is attached to a top parting sheet 38. The parting sheet 38 provides a top layer to seal a conduit through which a fluid medium is provided through inlets 42. A middle parting sheet 36 is disposed in a middle portion of the cold plate assembly and supports a closure bar 32. The closure bar 32 surrounds a finned layer 28. Fluid flows through the fins 28 to remove thermal energy produced by the heat generating devices 12. Although a single heat spreader 20 is shown, it is within the contemplation of this disclosure that additional heat spreaders could be included within the example cold plate assembly 10. For example, an additional heat spreader could be installed between the finned layers 28, 30 to further enhance heat removal.

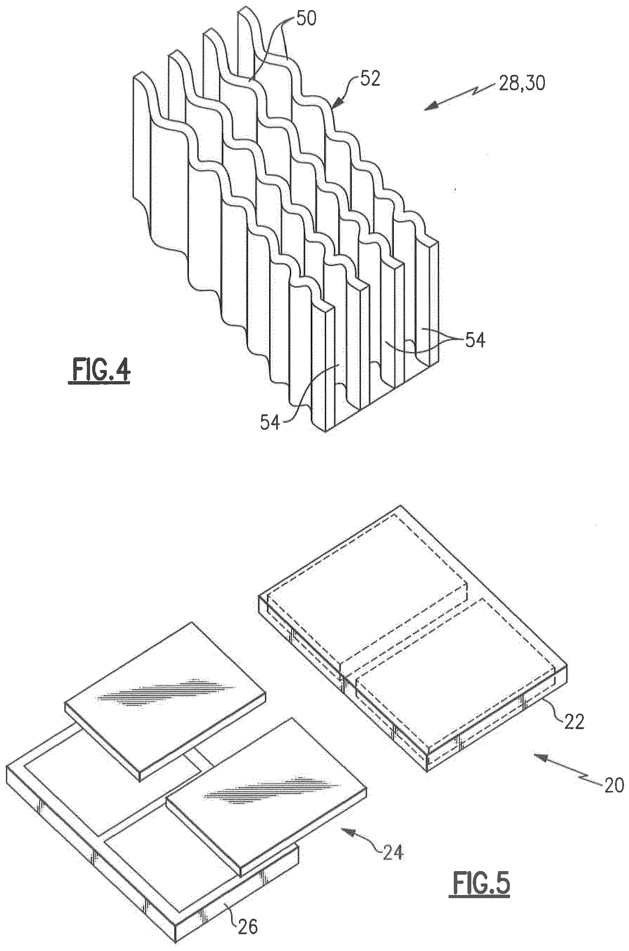

The example cold plate assembly includes a first layer 28 of fins and a second layer 30 of fins. Each of the layers of fins 28, 30 are bounded by closure bars 32, 34. The closure bars 32, 34 define a boundary for the various fluid passages that are defined between the plurality of fins 50 (Figure 4) within each of the layers 28, 30. A bottom parting sheet 40 is disposed on a bottom surface of the second layer 30 of fins that is opposite the middle parting sheet 36. The end sheet 18 is disposed in contact with the bottom parting sheet 40.

In this example, each of the parting sheets 36, 38, and 40 comprise an aluminum sheet material that is brazed in place to form the desired fluid conduits through which a cooling medium is provided. Each of the parting sheets 36, 38, and 40 of the example cold plate assembly 10 are brazed to each other at brazed joints indicated at 48. The heat spreader assembly 20 is further attached by a brazed joint 46 with the top parting sheet 38.

The example heat spreader assembly 20 includes the upper skin 22, a middle skin 24, and a lower skin 26. The middle skin 24 comprises a material that is selected from a group of materials that provides for the dissipation in a direction transverse to a thickness of the sheet. In other words, the heat spreader assembly 20 is comprised of layers of material that not only provide a low thermal resistance in a direction through the thickness of the material but also spreads the heat in a direction perpendicular to the thickness of the material about the area of the mounting surface 14. The outer skins 22, 26 are of a material brazeable and that mechanically encapsulate the center skin 24.

In this example, the heat spreader 20 comprises a material including graphite. The graphite provides for the spreading of thermal energy produced by the various heat generating components 12 across the area of the mounting surface 14 as indicated by arrows shown in Figure 1. In this example, the heat spreader center skin 24 is fabricated from annealed pyrolytic graphite (APG). As should be appreciated, although an APG material is used in the disclosed example cold plate assembly 10 and heat spreader assembly 20 other materials and configurations that provide for the spreading of heat are also within the contemplation of this disclosure. The outer skins 22, 26 are comprised of material that is brazeable to the other cold plate components.

Referring to Figure 4 with continued reference to Figure 2, the example fin layers 28 and 30 comprise a ruffled fin configuration. Each of the layers 28 and 30 comprise a plurality of fins 50 that are spaced apart to define passages 54 through which a cooling medium may be flowed. Each of the example fins 50 comprises a surface 52 that includes a wavy or undulating surface referred to as a ruffle. The ruffled surface defines walls for the passages 54. The undulated surface 52 defines a tortuous path for cooling medium that enhance the cooling efficiency of the example cooling plate assembly 10. Moreover, with the ruffled undulating configuration of the example finned layers 28, 30 increases the surface area available for dissipation of heat and communicating the heat between the plurality of fins 50 and a cooling medium that flows there through. Although finned layers 28, 30 having ruffled configuration are shown by way of example, other fin configurations are within the contemplation of this disclosure. As appreciated, the cooling medium can includes air, liquid, or gas as is required for a specific application.

Referring to Figure 5 with continued reference to Figures 2 and 3, the example heat spreader assembly 20 includes a top skin 22 and a bottom skin 26 that sandwiches a middle skin 24 there between. Each of the top and bottom skins 22, 26 are fabricated of a brazeable material. The middle skin 24 of the example heat spreader assembly is fabricated from an APG material. The APG material provides for the dissipation and spreading of heat in a direction that is perpendicular to a thickness of the heat spreader assembly.

The brazed joint 46 between the heat spreader assembly and the remainder of the cold plate assembly 10 provides a less restrictive thermal conduit through which heat may be dissipated from the mounting surface 14 through the top or first parting sheet 38 into the fin sections 28, 30 where the heat may be carried off by a flow of cooling medium indicated at 58 in Figure 1.

Referring to Figures 2 and 3, the example cold plate assembly 10 is assembled by mounting the layer of fins 28, 30 to first and second sides of the middle sheet 36. Each of the layers of fins 28, 30 are then surround by closure bars 32, 34 to define a boundary for cooling medium. In the disclosed example, the fin sections 28, 30 comprise ruffled fins that have an undulating surface. Onto each side of the fin layers 28, 30 is brazed and attached parting sheets 38, 40 to define and passages through the fin sections 28, 30 by closing off one side of the passages 54 through the fins 50. In this example, the top (first) parting sheet 38 is attached utilizing a brazed joint 48 to a top surface of the closure bar 32 and the accompanying fin layer 28. A corresponding bottom (second) sheet 40 is attached through brazed joint 48 to the closure bar 34 and over the fin layer 30.

The example heat spreader assembly 20 is assembled as a separate unit by attaching the upper skin 22 and the lower skin 26 to the middle layer 24. The attachment may be performed utilizing welding, brazing, or any other attachment means as is known. Once the heat spreader assembly 20 is completed it is mounted by way of the brazed joint 46 to the partially assembled parts to complete the example cold plate assembly 10. All of the joints are brazed to provide the desired fluid tightness and thermal conductivity.

The example cold plate assembly 10 includes the heat spreader assembly 20 that defines the mounting surface 14 and provides an improved thermal conduction of heat away from the heat generating devices 12. The example cold plate assembly 10 with the heat spreading assembly 20 spreads heat throughout the area of the mounting surface 14 produced by the heat generating devices 12 to reduce nonuniform thermal gradients across the cold plate assembly 10. Utilizing the example heat spreader assembly 20, the thermal gradient across the mounting surface 14 of the cold plate assembly 10 is substantially uniform and improves thermal conductivity and cooling provided by the cold plate assembly.

Although an example embodiment has been disclosed, a worker of ordinary skill in this art would recognize that certain modifications would come within the scope of this disclosure. For that reason, the following claims should be studied to determine the scope and content of this disclosure.

## Claims

1. A cold plate assembly (10) comprising:
a heat spreader (20) including a mounting side defining a surface (14) for mounting heat generating devices (12), wherein the heat spreader comprises an upper skin (22), a bottom skin (26) and a middle layer (24) different than the upper skin and the bottom skin that provides dissipation of heat in a direction transverse to a thickness of the middle layer;
a first heat dissipating member including walls spaced apart from each other to define passages for a cooling medium, wherein the walls are disposed transverse to the mounting side (14) of the heat spreader (20) and comprise rows of ruffled fins (28) bounded by a first parting sheet (38) in thermal communication with the lower skin (26) of the heat spreader and a second parting sheet (36); the first fin assembly comprising a first closure bar (32) surrounding the first layer of ruffled fins (28) and a second closure bar (34) surrounding the second layer of ruffled fins (30);
a second heat dissipating member including walls spaced apart to define passages for a cooling medium, wherein the walls of the second heat dissipating member comprises rows of ruffled fins (30) bounded at an upper surface by the second parting sheet (36) and at a lower surface by a third parting sheet (40); and an end sheet (18) defining a surface opposite the heat spreader (20).

2. The cold plate assembly as recited in claim 1, wherein the middle layer of the heat spreader (20) comprises a graphite material.

3. The cold plate assembly as recited in claim 2, wherein the middle layer of the heat spreader (20) comprises an annealed pyrolytic graphite.

4. The cold plate assembly as recited in claim 1, including an inlet and outlet for communicating a cooling medium through the first and second layers of ruffled fins.

5. The cold plate assembly as recited in claim 1, including a brazed joint attaching the heat spreader (20) to the first parting sheet.

6. A method of assembling a cold plate as claimed in claims 1 to 5 comprising:
defining a mounting surface (14) with a heat spreader (20) including an upper skin, a bottom skin and a middle layer different than the upper skin and the bottom skin that provides dissipation of heat in a direction transverse to a thickness of the middle layer;
attaching the heat spreader (20) to a fin assembly including a plurality of ruffled fins (28, 30); and
attaching an end sheet to a side of the fin assembly opposite the heat spreader; and including defining a fluid passage through the heat dissipating layer through the ruffled fins (28, 30), and wherein the first fin assembly includes a first parting sheet (38) defining a first surface of the fin assembly, a first closure bar (32) surrounding the plurality of ruffled fins and a second parting sheet (36) defining a second surface opposite to the first surface to which the heat spreader is attached; and
wherein the second fin assembly includes a second parting sheet (36) defining a first surface of the fin assembly, a second closure bar (34) surrounding the plurality of ruffled fins (30) and a third parting sheet (38) defining a second surface opposite to the first surface to which the heat spreader (20) is attached.

7. The method as recited in claim 6, wherein the middle layer of the heat spreading material (24) comprises annealed pyrolytic graphite.

8. The method as recited in claim 6, including attaching an inlet fitting (42) to the first parting sheet to define a fluid inlet and attaching an outlet fitting (44) to the first parting sheet to define a fluid outlet.

9. The method as recited in claim 6 or 8, including attaching the heat spreader (20) to the fin assembly with a brazed joint (46).

## Patentansprüche

1. Kühlplattenanordnung (10), umfassend:
einen Wärmeverteiler (20), der eine Montageseite umfasst, die eine Fläche (14) zum Montieren von wärmeerzeugenden Vorrichtungen (12) definiert, wobei der Wärmeverteiler eine obere Hülle (22), eine untere Hülle (26) und eine Mittelschicht (24) umfasst, die sich von der oberen Hülle und der unteren Hülle unterscheidet und die die Ableitung von Wärme in einer Richtung quer zu einer Dicke der Mittelschicht bereitstellt;
ein erstes wärmeableitendes Element, das Wände umfasst, die voneinander entfernt sind, um Durchgänge für ein Kühlmittel zu definieren, wobei die Wände quer zur Montageseite (14) des Wärmeverteilers (20) angeordnet sind und Reihen von gewellten Rippen (28) umfassen, die von einer ersten Trennplatte (38) in thermischer Kommunikation mit der unteren Hülle (26) des Wärmeverteilers und einer zweiten Trennplatte (36) begrenzt werden;
wobei die erste Rippenanordnung eine erste Verschlussleiste (32), die die erste Schicht von gewellten Rippen (28) umgibt, und eine zweite Verschlussleiste (34) umfasst, die die zweite Schicht von gewellten Rippen (30) umgibt;
ein zweites wärmeableitendes Element, das Wände umfasst, die voneinander entfernt sind, um Durchgänge für ein Kühlmittel zu definieren, wobei die Wände des zweiten wärmeableitenden Elements Reihen von gewellten Rippen (30) umfasst, die an einer oberen Fläche durch die zweite Trennplatte (36) und an einer unteren Fläche durch eine dritte Trennplatte (40) begrenzt werden; und
eine Endplatte (18), die eine Fläche definiert, die dem Wärmeverteiler (20) gegenüberliegt.

2. Kühlplattenanordnung nach Anspruch 1, wobei die Mittelschicht des Wärmeverteilers (20) ein Graphitmaterial umfasst.

3. Kühlplattenanordnung nach Anspruch 2, wobei die Mittelschicht des Wärmeverteilers (20) einen geglühten pyrolytischen Graphit umfasst.

4. Kühlplattenanordnung nach Anspruch 1, umfassend einen Einlass und einen Auslass zum Leiten eines Kühlmediums durch die erste und die zweite Schicht gewellter Rippen.

5. Kühlplattenanordnung nach Anspruch 1, umfassend eine Hartlötverbindung, die den Wärmeverteiler (20) an der ersten Trennplatte befestigt.

6. Verfahren zum Zusammenbauen einer Kühlplatte nach den Ansprüchen 1 bis 5, umfassend:
Definieren einer Montagefläche (14) mit einem Wärmeverteiler (20), der eine obere Hülle, eine untere Hülle und eine Mittelschicht umfasst, die sich von der oberen Hülle und der unteren Hülle unterscheidet und die die Ableitung von Wärme in einer Richtung quer zu einer Dicke der Mittelschicht bereitstellt;
Befestigen des Wärmeverteilers (20) an einer Rippenanordnung, die eine Vielzahl gewellter Rippen (28, 30) umfasst; und
Befestigen einer Endplatte an einer Seite der Rippenanordnung gegenüber dem Wärmeverteiler;
und umfassend das Definieren eines Fluiddurchgangs durch die wärmeableitende Schicht durch die gewellten Rippen (28, 30), und wobei die erste Rippenanordnung eine erste Trennplatte (38), die eine erste Fläche der Rippenanordnung definiert, eine erste Verschlussleiste (32), die die Vielzahl von gewellten Rippen umgibt, und eine zweite Trennplatte (36) umfasst, die eine zweite Fläche gegenüber der ersten Fläche, an der der Wärmeverteiler befestigt ist, definiert; und
wobei die zweite Rippenanordnung eine zweite Trennplatte (36), die eine erste Fläche der Rippenanordnung definiert, eine zweite Verschlussleiste (34), die die Vielzahl von gewellten Rippen (30) umgibt, und eine dritte Trennplatte (38) umfasst, die eine zweite Fläche gegenüber der ersten Fläche, an der der Wärmeverteiler (20) befestigt ist, definiert.

7. Verfahren nach Anspruch 6, wobei die Mittelschicht des wärmeverteilenden Materials (24) geglühten pyrolytischen Graphit umfasst.

8. Verfahren nach Anspruch 6, umfassend das Befestigen einer Einlassarmatur (42) an der ersten Trennplatte, um einen Fluideinlass zu definieren, und einer Auslassarmatur (44) an der ersten Trennplatte, um einen Fluidauslass zu definieren.

9. Verfahren nach Anspruch 6 oder 8, umfassend das Befestigen des Wärmeverteilers (20) an der Rippenanordnung mit einer Hartlötverbindung (46).

## Revendications

1. Ensemble de plaque froide (10) comprenant :
un dissipateur de chaleur (20) incluant un côté de montage définissant une surface (14) destinée à monter des dispositifs générateurs de chaleur (12), dans lequel le dissipateur de chaleur comprend une peau supérieure (22), une peau de dessous (26) et une couche milieu (24) différente de la peau supérieure et de la peau de dessous qui assure une dissipation de chaleur dans une direction transversale à une épaisseur de la couche milieu ;
un premier organe dissipateur de chaleur incluant des parois espacées les unes des autres pour définir des passages pour un milieu de refroidissement, dans lequel les parois sont disposées transversalement au côté de montage (14) du dissipateur de chaleur (20) et comprennent des rangées d'ailettes froissées (28) bornées par une première feuille de cloisonnement (38) en communication thermique avec la peau inférieure (26) du dissipateur de chaleur et une deuxième feuille de cloisonnement (36) ;
le premier ensemble d'ailette comprenant une première barre de fermeture (32) entourant la première couche d'ailettes froissées (28) et une seconde barre de fermeture (34) entourant la seconde couche d'ailettes froissées (30) ;
un second organe dissipateur de chaleur incluant des parois espacées pour définir des passages pour un milieu de refroidissement, dans lequel les parois du second organe dissipateur de chaleur comprennent des rangées d'ailettes froissées (30) bornées au niveau d'une surface supérieure par la deuxième feuille de cloisonnement (36) et au niveau d'une surface inférieure par une troisième feuille de cloisonnement (40) ; et
une feuille d'extrémité (18) définissant une surface opposée au dissipateur de chaleur (20).

2. Ensemble de plaque froide selon la revendication 1, dans lequel la couche milieu du dissipateur de chaleur (20) comprend un matériau de graphite.

3. Ensemble de plaque froide selon la revendication 2, dans lequel la couche milieu du dissipateur de chaleur (20) comprend un graphite pyrolytique recuit.

4. Ensemble de plaque froide selon la revendication 1, incluant une admission et un refoulement pour faire communiquer un milieu de refroidissement à travers les première et seconde couches d'ailettes froissées.

5. Ensemble de plaque froide selon la revendication 1, incluant un joint brasé fixant le dissipateur de chaleur (20) à la première feuille de cloisonnement.

6. Procédé d'assemblage d'une plaque froide telle que revendiquée dans les revendications 1 à 5, comprenant :
la définition d'une surface de montage (14) avec un dissipateur de chaleur (20) incluant une peau supérieure, une peau de dessous et une couche milieu différente de la peau supérieure et de la peau de dessous qui assure une dissipation de chaleur dans une direction transversale à une épaisseur de la couche milieu ;
la fixation du dissipateur de chaleur (20) à un ensemble d'ailette définissant une pluralité d'ailettes froissées (28, 30) ; et
la fixation d'une feuille d'extrémité à un côté de l'ensemble d'ailette opposé au dissipateur de chaleur ; et incluant la définition d'un passage de fluide à travers la couche de dissipation de chaleur à travers les ailettes froissées (28, 30), et dans lequel le premier ensemble d'ailette inclut une première feuille de cloisonnement (38) définissant une première surface de l'ensemble d'ailette, une première barre de fermeture (32) entourant la pluralité d'ailettes froissées et une seconde feuille de cloisonnement (36) définissant une seconde surface opposée à la première surface à laquelle est fixé le dissipateur de chaleur ; et
dans lequel le second ensemble d'ailette inclut une seconde feuille de cloisonnement (36) définissant une première surface de l'ensemble d'ailette, une seconde barre de fermeture (34) entourant la pluralité d'ailettes froissées (30) et une troisième feuille de cloisonnement (38) définissant une seconde surface opposée à la première surface à laquelle est fixé le dissipateur de chaleur (20).

7. Procédé selon la revendication 6, dans lequel la couche milieu du matériau dissipateur de chaleur (24) comprend du graphite pyrolytique recuit.

8. Procédé selon la revendication 6, incluant la fixation d'un accessoire d'admission (42) à la première feuille de cloisonnement pour définir une admission de fluide et la fixation d'un accessoire de refoulement (44) à la première feuille de cloisonnement pour définir un refoulement de fluide.

9. Procédé selon la revendication 6 ou 8, incluant la fixation du dissipateur de chaleur (20) à l'ensemble d'ailette avec un joint brasé (46).
